# EUROPEAN PATENT SPECIFICATION

(11) **EP 4 697 031 B1**
(45) Date of publication and mention of the grant of the patent: **13.05.2026**
(21) Application number: 24194644.1
(22) Date of filing: 14.08.2024
(51) Int. Cl.: G01R 15/18

(54) **PLANAR FLEXIBLE NON-INVASIVE CURRENT SENSOR WITH NON-MAGNETIC CORE**
PLANARER, FLEXIBLER, NICHT-INVASIVER STROMSENSOR MIT NICHT-MAGNETISCHEM KERN
CAPTEUR DE COURANT PLANAIRE FLEXIBLE NON INVASIF AVEC NOYAU NON MAGNÉTIQUE

(43) Date of publication of application: 18.02.2026
(73) Proprietor: Applied Invest s.r.o., 831 04 Bratislava (SK)
(72) Inventor: Grno, Ladislav, Bratislava (SK)
(74) Representative: inventa Patentova a znamkova kancelaria s.r.o.

(56) References cited:
- JP-B2- 6 479 370
- US-A1- 2003 090 356
- US-A1- 2020 379 017

## Description

### Field of the invention

The invention relates to the arrangement of the planar flexible non-invasive sensors for measuring alternating electric current. The invention falls within the field of electrical engineering.

### Background of the invention

The flexible electric current sensors are based on a slender induction coil repeatedly shapeable so that it forms a closed path about the current conductor to be measured. The voltage induced into the coil is proportional to the derivative of the total current flowing through the closed area. This principle of measurement is also commonly known as the Rogowski principle or Rogowski coil according to the publication Rogowski W. and Steinhaus W., from 1912. The flexible electric current sensor consists of the sensing winding wound on the cylindrical flexible core, the possible electrical shield located above the mentioned sensing winding, and the outer insulating sheath. To convert the output voltage of sensor to the signal proportional to total current, the electronic integrator is usually used as part of the flexible sensor. Flexible sensors are advantageous for measuring current in large conductors, shaped conductors and conductor groups. Known designs of flexible current sensors have lower amplitude and phase accuracy compared to transformer-type sensors. The accuracy of flexible current sensors is affected by residual signals induced by inductive coupling to external sources of current signals and by the variable inductive coupling of the sensing coil to the conductor to be measured.

Various arrangements of the Rogowski coil and associated electronics can be found in the references cited herein: Patent Application GB2259150A discloses the arrangement of electronic integrator with combined feedback, Patent Document US5442280 discloses the arrangement of fixed Rogowski coil as assembly on the printed circuit board, European Patent Application EP652441A1 discloses the arrangement of fixed Rogowski coil for installations with grounded metallic housing, Patent Document US6614218B1 discloses the arrangement of fixed Rogowski coil of electronic integrator with combined passive and active feedback, European patent application EP0834745A2 presents the arrangement of fixed Rogowski coil with high winding homogeneity, patent document JP2000065866 presents the arrangement of multiple Rogowski coils for measuring currents flowing through large structures, patent application GB2332784A presents the arrangement of flexible Rogowski coil wound on fixed support structure, patent application DE19811366A1 presents the arrangement of flexible Rogowski coil optimized for repetitive measurements on power conductors, patent application GB2342783A presents the arrangement of fixed Rogowski coil on the printed circuit board, patent application DE19959789A1 presents the arrangement of electronic integrator with switched feedback, patent document US6825650B1 presents the arrangement of multiple Rogowski coils for current measurements in electricity meters, patent document US6313623B1 presents the spatial arrangement of two Rogowski coils for elimination of residual signals, patent application US2003/0090356A1 presents the arrangement of fixed Rogowski coil on the printed circuit board with optical transmission line. Patent document US 7,847,543 B2 discloses the arrangement of sensing coil and electrical shielding structure improving accuracy and independence from external magnetic and electric fields.

Patent document JP 6479370 B2 discloses a flexible current sensor that can easily wrap around various objects to measure electrical current, making it adaptable for different applications. It consists of a magnetic core covered with insulating layers and conductive stripes, allowing it to function effectively while maintaining flexibility.

Patent document US 2020379017A1 discloses a closed loop current transducer designed to measure electrical currents with high precision by using a specialized sensing unit that detects magnetic fields.

In the state of the art, the electric current sensor described in European patent application EP3566061A1 is also known. The sensor consists of sensing coil wound on cylindrical flexible core, wherein the mentioned sensing coil consists of two series-connected overlapping windings wound along the mentioned cylindrical flexible core in mutually opposite direction.

The cylindrical flexible core consists of plurality of filaments of non-magnetic material arranged to the nearest approximation of circular cross-section, and the sensing coil is further provided with non-conductive separating layer disposed between its windings. The disadvantage of this sensor is the difficult manufacturing of the winding coils and the overall difficult assembly of the sensor. Principal linearity, the absence of saturation of the non-magnetic core as well as a large frequency range are inherent properties of flexible current sensors that call the demand for their further refinement and application-oriented optimization. The aim of the present invention is to find the solution corresponding to the above mentioned requirements.

### Summary of the invention

The object of the present invention is to design a planar electric current sensor that measures alternating electric current, with high accuracy even in non-homogeneous magnetic field, has low power consumption, is easy to integrate into existing devices even without interrupting the current circuit, which would be suitable for mass production with low implementation costs, and which would also be easier to assemble in a real application.

This problem is solved by the present invention, the essence of which is that the planar flexible non-invasive sensor for measuring alternating electric current in the basic arrangement comprises the planar flexible core comprising at least one strip of non-magnetic metallic electrically conductive material. As suitable non-magnetic metal, for example, aluminium or copper can be advantageously used. The individual strips of planar flexible core are electrically insulated from each other. Preferably, each of the strips of planar flexible core is covered with the insulating layer. As the insulating layer, preferably lacquer or oxidation coating of the surface or strip of insulating material may be used.

According to the first aspect of the present invention, the strip of planar flexible core has the constant solid rectangular cross-section. According to the further aspect of the present invention, the strip of planar flexible core has the meander shape with the constant effective width symmetrically arranged about the longitudinal axis of the planar flexible core. For the purposes of the present invention, the term "meander with constant effective width" refers to a meander arrangement in which the outermost points of its opposite arms have the same distance from the longitudinal axis of the meander. The advantageous meander strip arrangement further improves the flexibility and mechanical properties of the sensor.

The planar flexible core according to the present invention is continuously surrounded by at least one sensing planar structure from which it is electrically insulated, formed by transverse segments of electrically conductive material electrically isolated above and below the planar flexible core, evenly spaced along the entire length of the planar flexible core, wherein the transverse segments are connected in series with each other by connecting elements to form at least one homogeneous winding. In the case of carrying out the present invention with the plurality of sensing planar structures, the windings formed by these structures are electrically conductively connected in series.

The planar flexible core with sensing planar structures is advantageously arranged with connecting openable means at its ends to form closed loop of the core surrounding the current conductor. Preferably, at location of the connecting openable means, the compensating winding is electrically insulated around the planar flexible core and connected in series to the sensing planar structure to compensate local non-homogeneity of the sensor at location of the closing connection.

When the planar flexible non-invasive current sensor preferably comprises one sensing planar structure, the end of the winding formed by this structure is electrically preferably led to the location of the beginning of this winding by the strip of the planar flexible core. Thereafter, one end of the strip and one end of the sensing planar structure are led at one end of the planar flexible core, which are the outputs of the planar flexible non-invasive current sensor itself.

If the planar flexible non-invasive current sensor preferably comprises two sensing planar structures, then there are several possibilities of implementation. In one case, the transverse segments of the first sensing planar structure and the second sensing planar structure are preferably arranged in one plane alternately side by side. The two sensing planar structures arranged in this manner form two mechanically parallel windings. The two windings are electrically connected in series such that the end of the first winding is electrically connected with the beginning of the second winding by the first conductive strip of the planar flexible core, and the end of the second winding is led to the location of the beginning of the first winding by the second conductive strip of the planar flexible core.

In this way, the symmetrical structure of the planar flexible non-invasive current sensor is advantageously formed, in which at one end of the planar flexible core, the beginning of the first sensing planar structure is the negative output of the sensor, and the second strip of the planar flexible core is the positive output of the planar sensor, and the first strip of the planar flexible core is the electrical center of the winding and forms the reference output of the planar sensor. This eliminates external induced disturbances degrading the accuracy of the planar sensor in the differential measurement connection.

According to the further aspect of the present invention, the transverse segments of the first and second sensing planar structures are advantageously arranged one above the other in two planes. Here, it is preferably possible for the transverse segments with connecting elements of the first sensing planar structure and the transverse segments with connecting elements of the second sensing planar structure in the second plane to form two windings with mutually opposite directional orientation. In this case, the end of winding of the first planar sensing structure is directly connected with the same end of the second planar sensing structure, which thereby forms the return conductor forming the contact points of the sensing planar structure at the same end of the planar flexible non-invasive current sensor.

The planar flexible non-invasive sensor for measuring alternating electric current, according to the further aspect of the present invention, may advantageously comprise the shielding planar structure preferably formed of two layers of conductive material, the thickness of which is substantially less than the thickness of the planar flexible core, wherein the first layer of the shielding planar structure is disposed on the outer side of the sensing planar structure on one side away from the planar flexible core, and the second layer of the shielding planar structure is disposed on the outer side of the sensing planar structure on the other side away from the planar flexible core. The layers of the planar shielding structure preferably comprise plurality of transverse segments electrically conductively connected to each other in one case. Such arrangement of the layers of the shielding planar structure further improves the bending flexibility of the sensor. In another case of advantageous embodiment of the present invention, each layer of the planar shielding structure is formed by continuous strips, which in this case also improves the protection thereof.

Advantages of the planar flexible non-invasive alternating electric current measurement sensor according to the invention comprising the sensing coil wound on the planar flexible core, wherein the flexible core consists of at least one strip of non-magnetic metallic material resulting from the planar core providing improved flexibility of the planar sensor, minimization of eddy currents in the core, and better approximation of the theoretically defining linear integration of the magnetic field.

The metal core material will ensure long-term dimensional and thermal stability of the sensor due to the generally better mechanical and thermal properties of metal compared to flexible plastics.

The linearity of the sensor is ensured by using of non-magnetic metal. The mutual electrical isolation of the individual strips prevents the flow of circulating current in the core and thus improves the accuracy of the current measurement.

The form of the strip against the number of fibres allows, by reducing the thickness of the strip while increasing its width, to maintain the same cross-section of non-magnetic core material, i.e. it allows to maintain the resolution of the sensor for both small and large currents as well as the resistance to external influences, while reducing the thickness of the strip has the following advantages:
- increases the flexibility of the sensor and thus the possibility of reducing the diameter of circle of the closed sensor surrounding the conductor of the measured current, which increases the intensity of magnetic field and thus increases sensitivity of the sensor.
- increases fatigue resistance, thus increasing the lifetime of the sensor during repeated opening/closing cycles.
- increases accuracy of the sensor placed in non-homogeneous magnetic field due to better approximation of the definition line integration of magnetic field around the conductor of measured current.
- reduces the reverse influence of eddy currents in the cross-section of the strip on the dynamic measured magnetic field.

### Overview of the figures on the drawings

The planar flexible non-invasive current sensor for measuring alternating electric current proposed according to the invention is shown on the drawings, in which:
Fig. 1 shows the current sensor with the core formed by the single strip of homogeneous film of non-magnetic material, which is surrounded by one sensing planar structure.
Fig. 2 shows the current sensor with the core formed by two strips of non-magnetic conductive material, which are surrounded by two parallel sensing planar structures with segments arranged in the same plane with symmetrical sensor output.
Fig. 3 shows the current sensor with the core formed by one strip of non-magnetic conductive material, which is surrounded by two sensing planar structures with segments arranged in different planes so as to form two windings with opposite orientation to each other.
Fig. 4 shows the strip of flexible core in shape of the meander.
Fig. 5 shows the planar electric current sensor arranged such that the ends of the planar flexible core are provided with connecting openable means to form openable closed loop around the conductor with measured current.
Fig. 6 shows the planar electric current sensor with the planar shielding structure formed by electrically interconnected transverse segments.
Fig. 7 shows the connection of the symmetrical sensing structure to the differential amplifier.

### Examples of embodiments of the invention

The following specific examples of embodiments are provided for illustrative purposes only and should not be understood as limitations on the scope of protection given by the patent claims.

### Example 1

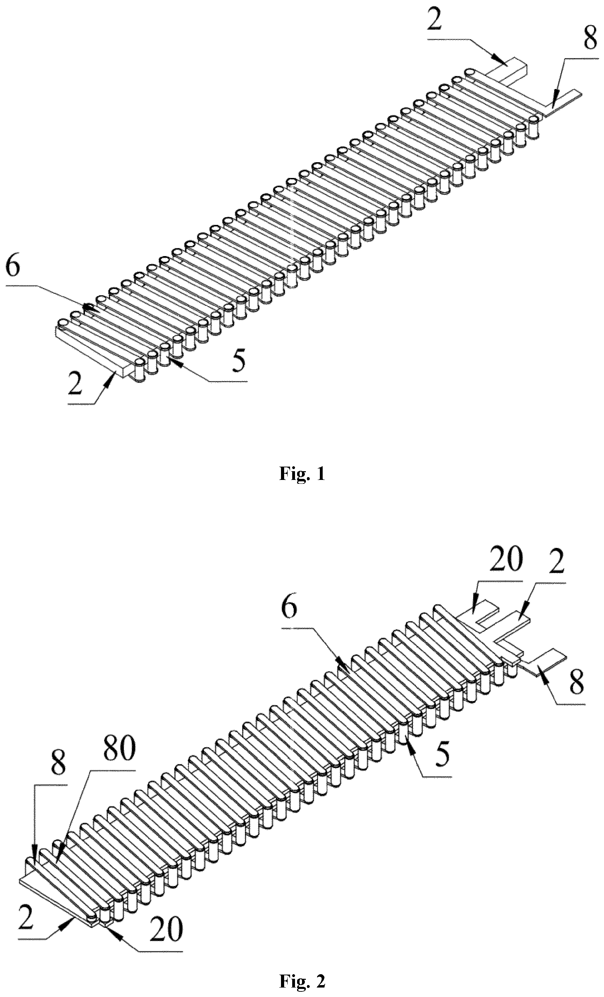

The basic arrangement of the planar flexible non-invasive current sensor for alternating electric current measurement is shown in Fig. 1. The illustrated arrangement presents the planar flexible non-invasive AC electric current sensor, in which the planar flexible core of non-magnetic metallic electrically conductive material in shape of the strip 2 is arranged along the entire length of the sensor, the thickness of the strip 2 being substantially less than the length of the planar sensor.

The strip 2 of the planar flexible core has constant full rectangular cross-section with connection plates at its both ends. The planar sensor further comprises an electrically insulated planar sensing structure 8 formed by transverse segments 6 of conductive material insulated above and below the planar flexible core evenly spaced along the entire length of the planar flexible core, which are the first connecting elements 5 mutually connected in series so that the sensing planar structure 8 continuously surrounds the planar flexible core and functionally represents the analogy of one homogeneous winding around the planar flexible core.

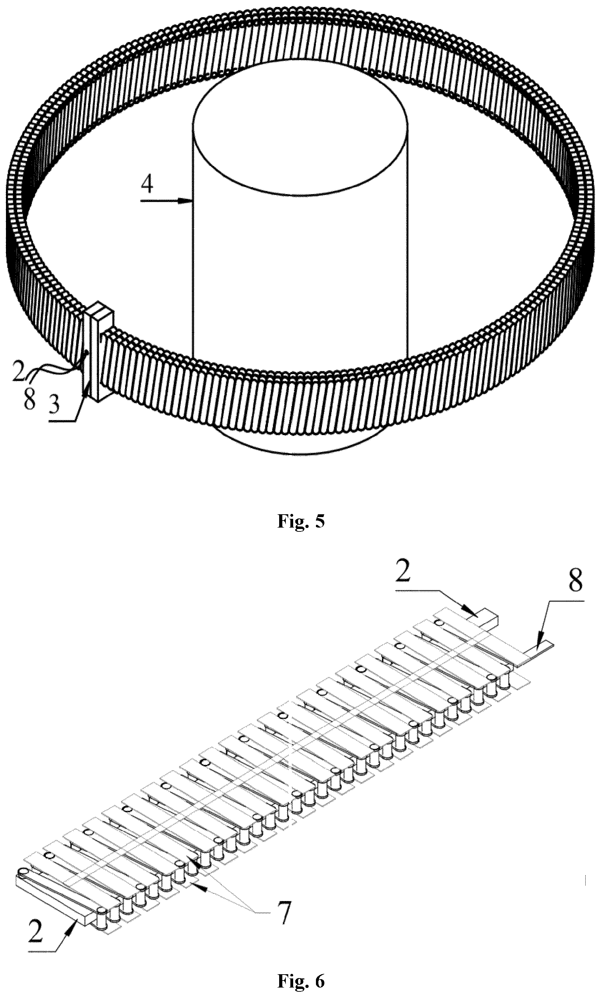

One end of the strip 2 and one end of the sensing planar structure 8, which are the output of the planar sensor, are led out at one end of the planar flexible core. At the other end of the planar flexible core, the other end of the strip 2 and the other end of the sensing planar structure form electrically conductive connection. The planar sensor is provided with connecting openable means 3 at the ends of the planar flexible core, so that the planar flexible core equipped with the sensing planar structure 8 and the strip 2 enables to form the closed loop surrounding the current conductor 4 as shown in Figure 5. Alternatively, at the location of the connecting opening means 3, the compensating winding is electrically insulatedly wound around the planar flexible core and connected with the sensing planar structure 8 in series.

### Example 2

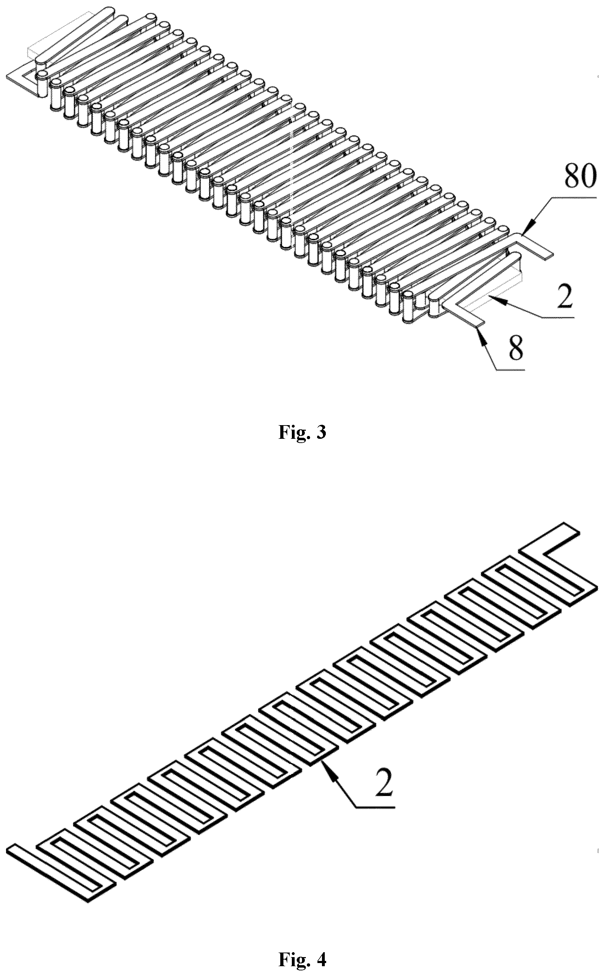

In this example of embodiment, the analogous arrangement of the planar flexible non-invasive current sensor for measuring alternating electric current is described. This arrangement is based on the previous example. The difference is in shape of the strip 2 of the planar flexible core, which is formed by the meander structure symmetrically arranged about the longitudinal axis of the planar flexible core as shown in FIG. 4.

### Example 3

In this example of embodiment, the derived arrangement of the planar flexible non-invasive current sensor with symmetrical output for AC electric current measurement is described, which is illustrated in Fig. 2. The illustrated solution presents the planar flexible non-invasive alternating electric current sensor, which comprises the planar flexible core formed by the first strip 2 and the second strip 20 of non-magnetic metallic electrically conductive material along the entire length of the sensor, which are electrically isolated from each other, wherein the thickness of the strips 2 is substantially less than the length of the planar sensor.

Both strips 2 and 20 of the planar flexible core have constant full rectangular cross-section with connection plates at both ends. The planar sensor further comprises the first sensing planar structure 8 and the second sensing planar structure 80, which are formed by transverse segments 6 of conductive material electrically isolated above and below the planar flexible core evenly spaced along the entire length of the planar flexible core. In doing so, the transverse segments 6 of the first and second sensing planar structures 8, 80 are arranged alternately side by side.

The transverse segments 6 are mutually connected with the connecting elements 5 so that the first and second sensing planar structures 8, 80 are connected in series with electrically conductive interconnection through the first strip 2 of the flexible core, wherein the end of the second sensing planar structure 80 is led to the location of the beginning of the first sensing planar structure 8. One end of the sensing planar structure 8 is the negative output of the planar sensor and one end of the second strip 20 is the positive output of the planar sensor. The first strip 2 of the flexible core forms the electrical center of the symmetrical structure and is the reference input for the differential amplifier 1.

### Example 4

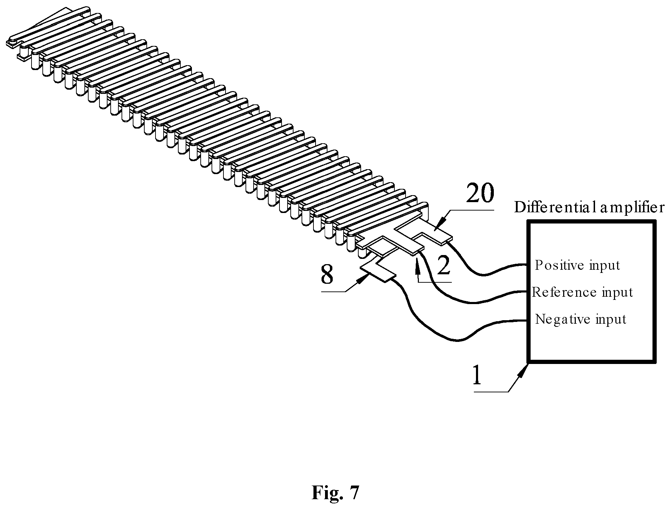

In this example of embodiment, the analogous arrangement of the planar flexible non-invasive current sensor for measuring alternating current described in Example 3 is described. The difference is in the symmetrical output, as shown in Fig. 7. The solution is that the first strip 2 of the planar flexible core is the reference output of the planar sensor connected to the differential amplifier 1.

### Example 5

Figure 3 describes the analogous arrangement of the planar flexible non-invasive current sensor for measuring alternating electric current. The transverse segments 6 of the first sensing planar structure 8 and the second sensing planar structure 80 are arranged above each other in two planes, wherein the transverse segments 6 of the first sensing planar structure 8 are oriented opposite to the transverse segments 6 of the second sensing planar structure 80. The first and second sensing planar structures 8, 80 are electrically conductively connected at one end of the planar flexible core formed by the strip 2. One end of the winding of the first sensing planar structure 8 is led out and one end of the winding of the second sensing planar structure 80 is also led out at the other end of the planar flexible core.

For all herein described examples of embodiments, they may advantageously comprise the shielding planar structure 7 formed of two structured layers of conductive material whose thickness is substantially less than the thickness of the planar flexible core, wherein the first layer of the shielding planar structure 7 is disposed below the sensing planar structure 8 and the second layer of the shielding planar structure 7 is disposed above the sensing planar structure 8 on the other side from the planar flexible core as shown in Fig. 6. The shielding planar structure 7 comprises plurality of electrically connected transverse segments. Alternatively, each layer of the shielding planar structure 7 is formed by continuous strip.

### Industrial applicability

The solution according to the present invention is intended for use in control and monitoring systems in various industrial applications requiring high-precision measurement of alternating electric current.

### List of reference numbers

- 1: differential amplifier
- 2: the first strip of the planar flexible core
- 20: the second strip of the planar flexible core
- 3: connecting openable means
- 4: current conductor
- 5: connecting elements
- 6: transverse segments
- 7: shielding planar structure
- 8: the first sensing planar structure
- 80: the second sensing planar structure

## Claims

1. A planar flexible non-invasive current sensor, comprising a planar flexible core comprising at least one strip (2, 20) of non-magnetic metallic electrically conductive material, wherein the strips (2, 20) of the planar flexible core are electrically isolated from each other, wherein the planar flexible core is surrounded by at least one sensing planar structure (8, 80) from which it is electrically isolated, comprising transverse segments (6) of electrically conductive material electrically isolated above and below the planar flexible core, evenly spaced along the entire length of the planar flexible core, and wherein the transverse segments (6) are electrically conductively coupled in series with each other by connecting elements (5), thereby form the homogeneous winding, **characterised in that** the strip (2, 20) of the planar flexible core has the shape of a meander with constant effective width, wherein its longitudinal axis is parallel to the longitudinal axis of the planar flexible core.

2. The planar flexible non-invasive current sensor according to claim 1, **characterized in that** at the ends of the planar flexible core there are arranged connecting openable means (3) for forming openable closed loops surrounding a current conductor (4) with the current to be measured.

3. The planar flexible non-invasive current sensor according to any one of the preceding claims, **characterized in that** it comprises one sensing planar structure (8) and one planar flexible core formed by one strip (2), wherein the first end of the strip (2) and the first end of the sensing planar structure (8) are led out at the first end of the planar flexible core, and wherein the second end of the strip (2) and the second end of the sensing planar structure are electrically conductively connected at the second end of the planar flexible core.

4. The planar flexible non-invasive current sensor according to any one of the preceding claims, **characterized in that** it comprises a first sensing planar structure (8) and a second sensing planar structure (80), wherein the first and second sensing planar structures (8, 80) are connected in series.

5. The planar flexible non-invasive current sensor according to claim 4, **characterized in that** the transverse segments (6) of the first sensing planar structure (8) and the second sensing planar structure (80) are arranged alternately side by side, that their series connection is formed by electrically conductively connecting the end of the first sensing planar structure (8) to the beginning of the second sensing planar structure (80) by a first strip (2) of the planar flexible core, and the end of the second sensing planar structure (80) is led to the location of the beginning of the first sensing planar structure (8) by a second strip (20) of the planar flexible core, wherein the beginning of the first sensing planar structure (8) is the negative output of the sensor and the second strip (20) of the planar flexible core is the positive output of the sensor.

6. The planar flexible non-invasive current sensor according to claim 5, **characterized in that** the first strip (2) of the planar flexible core is the reference output of the sensor.

7. The planar flexible non-invasive current sensor according to any one of claims 1 to 4, **characterized in that** the transverse segments (6) of the first sensing planar structure (8) and the second sensing planar structure (80) are arranged on each side of the planar flexible core above each other in two different planes.

8. The planar flexible non-invasive current sensor according to claim 7, **characterized in that** the transverse segments (6) of the first sensing planar structure (8) and the second sensing planar structure (80) are mutually oriented, that the winding formed by the transverse segments (6) and the connecting elements (5) of the first sensing planar structure (8) is oppositely oriented to the winding formed by the transverse segments (6) and the connecting elements (5) of the second sensing planar structure (80), wherein the series connection of the windings of the first sensing planar structure (8) and the second sensing planar structure (80) is formed by electrically conductively connecting the first end of the first sensing planar structure (8) with the first end of the second sensing planar structure (80) at the first end of the planar flexible core, wherein the second end of the winding of the first sensing planar structure (8) as well as the second end of the winding of the second sensing planar structure (80) is led out at the second end of the planar flexible core.

9. The planar flexible non-invasive current sensor according to any one of the preceding claims, **characterized in that** it comprises a shielding planar structure (7) made of two layers of conductive material, the thickness of which is substantially less than the thickness of the planar flexible core, wherein the first layer of the shielding planar structure (7) is electrically isolated from the outside of the sensing planar structure (8, 80) on the first side away from the planar flexible core, and the second layer of the shielding planar structure (7) is electrically isolated from the outside of the sensing planar structure (8, 80) on the second side away from the planar flexible core.

10. The planar flexible non-invasive current sensor according to claim 9, **characterized in that** the layers of the shielding planar structure (7) comprise a plurality of electrically interconnected transverse segments.

11. The planar flexible non-invasive current sensor according to any one of claims 8 to 9, **characterized in that** each layer of the shielding planar structure (7) is formed by a continuous strip.

12. The planar flexible non-invasive current sensor according to any one of the preceding claims, **characterized in that**, at the location of the connecting openable means (3), a compensating winding is electrically insulatingly wound around the planar flexible core and connected in series with the sensing planar structure (8, 80).

## Patentansprüche

1. Ein planarer flexibler nicht-invasiver Stromsensor, der einen planaren flexiblen Kern mit mindestens einem Streifen (2, 20) aus nichtmagnetischem metallischem elektrisch leitendem Material enthält, wobei die Streifen (2, 20) des planaren flexiblen Kerns voneinander elektrisch isoliert sind, wobei der planare flexible Kern mit mindestens einer planaren Abtaststruktur (8, 80) umgewickelt ist, von der er elektrisch isoliert ist, die gebildet ist durch die Quersegmente (6) aus elektrisch leitfähigem Material, die über und unter dem planaren flexiblen Kern elektrisch isoliert platziert sind, gleichmäßig über die gesamte Länge des planaren flexiblen Kerns verteilt, und wobei die Quersegmente (6) die Verbindungselemente (5) sind, elektrisch leitend untereinander in Serie verbunden, wodurch sie eine homogene Wicklung bilden, **dadurch gekennzeichnet, dass** der Streifen (2, 20) des planaren flexiblen Kerns die Form eines Mäanders mit einer konstanten effektiven Breite hat, wobei seine Längsachse parallel zur Längsachse des planaren flexiblen Kerns verläuft.

2. Ein planarer flexibler nicht-invasiver Stromsensor nach Anspruch 1, **dadurch gekennzeichnet, dass** an den Enden des planaren flexiblen Kerns öffnungsbare Verbindungsmittel (3) angeordnet sind, um eine öffnungsbare geschlossene Schleife zu bilden, die den Stromleiter (4) mit dem zu messenden Strom umwickelt.

3. Ein planarer flexibler nicht-invasiver Stromsensor nach einem beliebigen der vorhergehenden Ansprüche **dadurch gekennzeichnet, dass** er eine planare Abtaststruktur (8) und einen planaren flexiblen Kern aus einem Streifen (2) enthält, wobei das erste Ende des Streifens (2) und das erste Ende der planaren Abtaststruktur (8) am ersten Ende des planaren flexiblen Kerns herausgeführt sind, und wobei das andere Ende des Streifens (2) und das andere Ende der planaren Abtaststruktur am anderen Ende des planaren flexiblen Kerns elektrisch leitend verbunden sind.

4. Ein planarer flexibler nicht-invasiver Stromsensor nach einem beliebigen der vorhergehenden Ansprüche, **dadurch gekennzeichnet, dass** er die erste planare Abtaststruktur (8) und die zweite planare Abtaststruktur (80) enthält, wobei die erste und die zweite planare Abtaststruktur (8, 80) in Serie verbunden sind.

5. Ein planarer flexibler nicht-invasiver Stromsensor nach Anspruch 4, **dadurch gekennzeichnet, dass** die Quersegmente (6) der ersten planaren Abtaststruktur (8) und der zweiten planaren Struktur (80) abwechselnd nebeneinander so angeordnet sind, dass ihre Serienschaltung durch elektrisch leitende Verbindung des Endes der ersten planaren Abtaststruktur (8) mit dem Anfang der zweiten planaren Abtaststruktur (80) durch den ersten Streifen (2) des planaren flexiblen Kerns gebildet ist, und das Ende der zweiten planaren Abtaststruktur (80) zum Anfang der ersten planaren Abtaststruktur (8) mit dem zweiten Streifen (20) des planaren flexiblen Kerns geführt ist, wobei der Anfang der ersten planaren Abtaststruktur (8) der negative Sensorausgang ist, und der zweite Streifen (20) des planaren flexiblen Kerns der positive Ausgang des Sensors ist.

6. Ein planarer flexibler nicht-invasiver Stromsensor nach Anspruch 5, **dadurch gekennzeichnet, dass** der erste Streifen (2) des planaren flexiblen Kerns der Referenzausgang des Sensors ist.

7. Ein planarer flexibler nicht-invasiver Stromsensor nach einem beliebigen der Ansprüche 1 bis 4, **dadurch gekennzeichnet, dass** die Quersegmente (6) der ersten planaren Abtaststruktur (8) und der zweiten planaren Abtaststruktur (80) auf jeder Seite des planaren flexiblen Kerns übereinander in zwei unterschiedlichen Ebenen angeordnet sind.

8. Ein planarer flexibler nicht-invasiver Stromsensor nach Anspruch 7, **dadurch gekennzeichnet, dass** die Quersegmente (6) der ersten planaren Abtaststruktur (8) und der zweiten planaren Abtaststruktur (80) gegenübereinander so orientiert sind, dass die Wicklung, die durch die Quersegmente (6) und die Verbindungselemente (5) der ersten planaren Abtaststruktur (8) gebildet wird, umgekehrt orientiert ist als die Wicklung, die aus den Quersegmenten (6) und Verbindungselementen (5) der zweiten planaren Abtaststruktur (80) gebildet wird, wobei die Serienschaltung der Wicklungen der ersten planaren Abtaststruktur (8) und der zweiten planaren Abtaststruktur (80) durch die elektrisch leitende Verbindung des ersten Endes der ersten planaren Abtaststruktur (8) mit dem ersten Ende der zweiten planaren Abtaststruktur (80) am ersten Ende des planaren flexiblen Kerns gebildet ist, wobei am anderen Ende des planaren flexiblen Kerns das andere Ende der Wicklung der ersten planaren Abtaststruktur (8) als auch das andere Ende der Wicklung der zweiten planaren Abtaststruktur (80) herausgeführt ist.

9. Ein planarer flexibler nicht-invasiver Stromsensor nach einem beliebigen der vorhergehenden Ansprüche, **dadurch gekennzeichnet, dass** er eine planare Abschirmstruktur (7) enthält aus zwei Schichten leitenden Materials, dessen Stärke wesentlich geringer ist als die Stärke des planaren flexiblen Kerns, wobei die erste Schicht der planaren Abschirmstruktur (7) elektrisch isoliert von der Außenseite der planaren Abtaststruktur (8, 80) auf der ersten Seite vom planaren flexiblen Kern platziert ist, und die zweite Schicht der planaren Abschirmstruktur (7) elektrisch isoliert von der Außenseite der planaren Abtaststruktur (8, 80) auf der anderen Seite vom planaren flexiblen Kern platziert ist.

10. Ein planarer flexibler nicht-invasiver Stromsensor nach Anspruch 9, **dadurch gekennzeichnet, dass** die Schichten der planaren Abschirmstruktur (7) eine Menge von elektrisch miteinander verbundenen Quersegmenten enthalten.

11. Ein planarer flexibler nicht-invasiver Stromsensor nach einem beliebigen der Ansprüche 8 bis 9, **dadurch gekennzeichnet, dass** jede Schicht der planaren Abschirmstruktur (7) durch einen durchgehenden Streifen gebildet wird.

12. Ein planarer flexibler nicht-invasiver Stromsensor nach einem beliebigen der vorhergehenden Ansprüche, **dadurch gekennzeichnet, dass** am Ort der öffnungsbaren Verbindungsmittel (3) um den planaren flexiblen Kern herum eine Kompensationswicklung elektrisch isoliert aufgewickelt und an die planare Abtaststruktur (8, 80) in Serie verbunden ist.

## Revendications

1. Capteur de courant non invasif flexible et planaire, comprenant un noyau flexible planaire contenant au moins une bande (2, 20) d'un matériau métallique non magnétique électriquement conducteur, les bandes (2, 20) du noyau flexible planaire étant isolées électriquement les unes des autres, le noyau flexible planaire étant entouré par au moins une structure planaire de détection (8, 80), de laquelle il est isolé électriquement, formée par des segments transversaux (6) en matériau électriquement conducteur, disposés de manière isolée électriquement au-dessus et au-dessous du noyau flexible planaire, répartis uniformément sur toute la longueur du noyau flexible planaire, et dans lequel les segments transversaux (6) sont reliés électriquement entre eux en série par des éléments de connexion (5), créant ainsi un enroulement homogène, **caractérisé en ce que** la bande (2, 20) du noyau flexible planaire présente une forme de méandre avec une largeur effective constante, son axe longitudinal étant parallèle à l'axe longitudinal du noyau flexible planaire.

2. Capteur de courant non invasif flexible et planaire selon la revendication 1, **caractérisé en ce que** des moyens de connexion ouvrables (3) sont disposés aux extrémités du noyau flexible planaire pour former une boucle fermée ouvrable entourant un conducteur de courant (4) avec le courant mesuré.

3. Capteur de courant non invasif flexible et planaire selon l'une quelconque des revendications précédentes, **caractérisé en ce qu'**il comprend une structure planaire de détection (8) et un noyau flexible planaire formé par une seule bande (2), dans lequel la première extrémité de la bande (2) et la première extrémité de la structure planaire de détection (8) sont sorties à la première extrémité du noyau flexible planaire, et dans lequel la deuxième extrémité de la bande (2) et la deuxième extrémité de la structure planaire de détection sont connectées électriquement à la deuxième extrémité du noyau flexible planaire.

4. Capteur de courant non invasif flexible et planaire selon l'une quelconque des revendications précédentes, **caractérisé en ce qu'** il comprend une première structure planaire de détection (8) et une deuxième structure planaire de détection (80), la première et la deuxième structures planaires de détection (8, 80) étant connectées en série.

5. Capteur de courant non invasif flexible et planaire selon la revendication 4, **caractérisé en ce que** les segments transversaux (6) de la première structure planaire de détection (8) et de la deuxième structure planaire de détection (80) sont disposés alternativement côte à côte de sorte que leur connexion en série est formée par la liaison électrique de l'extrémité de la première structure planaire de détection (8) avec le début de la deuxième structure planaire de détection (80) par la première bande (2) du noyau flexible planaire, et l'extrémité de la deuxième structure planaire de détection (80) est ramenée à l'endroit du début de la première structure planaire de détection (8) par la deuxième bande (20) du noyau flexible planaire, le début de la première structure planaire de détection (8) étant la sortie négative du capteur et la deuxième bande (20) du noyau flexible planaire étant la sortie positive du capteur.

6. Capteur de courant non invasif flexible et planaire selon la revendication 5, **caractérisé en ce que** la première bande (2) du noyau flexible planaire est la sortie de référence du capteur.

7. Capteur de courant non invasif flexible et planaire selon l'une quelconque des revendications 1 à 4, **caractérisé en ce que** les segments transversaux (6) de la première structure planaire de détection (8) et de la deuxième structure planaire de détection (80) sont disposés l'un au-dessus de l'autre dans deux plans différents de chaque côté du noyau flexible planaire.

8. Capteur de courant non invasif flexible et planaire selon la revendication 7, **caractérisé en ce que** les segments transversaux (6) de la première structure planaire de détection (8) et de la deuxième structure planaire de détection (80) sont orientés mutuellement de sorte que l'enroulement formé par les segments transversaux (6) et les éléments de connexion (5) de la première structure planaire de détection (8) est orienté de manière opposée à l'enroulement formé par les segments transversaux (6) et les éléments de connexion (5) de la deuxième structure planaire de détection (80), la connexion en série des enroulements de la première structure planaire de détection (8) et de la deuxième structure planaire de détection (80) étant formée par la liaison électrique de la première extrémité de la première structure planaire de détection (8) avec la première extrémité de la deuxième structure planaire de détection (80) à la première extrémité du noyau flexible planaire, tandis qu'à la deuxième extrémité du noyau flexible planaire sont sorties la deuxième extrémité de l'enroulement de la première structure planaire de détection (8) ainsi que la deuxième extrémité de l'enroulement de la deuxième structure planaire de détection (80).

9. Capteur de courant non invasif flexible et planaire selon l'une quelconque des revendications précédentes, **caractérisé en ce qu'** il comprend une structure planaire de blindage (7) constituée de deux couches de matériau conducteur, dont l'épaisseur est sensiblement inférieure à l'épaisseur du noyau flexible planaire, la première couche de la structure planaire de blindage (7) étant placée de manière isolée électriquement sur le côté extérieur de la structure planaire de détection (8, 80) d'un premier côté du noyau flexible planaire, et la deuxième couche de la structure planaire de blindage (7) étant placée de manière isolée électriquement sur le côté extérieur de la structure planaire de détection (8, 80) du deuxième côté du noyau flexible planaire.

10. Capteur de courant non invasif flexible et planaire selon la revendication 9, **caractérisé en ce que** les couches de la structure planaire de blindage (7) comprennent une pluralité de segments transversaux interconnectés électriquement.

11. Capteur de courant non invasif flexible et planaire selon l'une quelconque des revendications 8 à 9, **caractérisé en ce que** chaque couche de la structure planaire de blindage (7) est formée par une bande continue.

12. Capteur de courant non invasif flexible et planaire selon l'une quelconque des revendications précédentes, **caractérisé en ce qu'** au niveau des moyens de connexion ouvrables (3), un enroulement de compensation est enroulé de manière isolée électriquement autour du noyau flexible planaire et connecté en série à la structure planaire de détection (8, 80).
